Europäisches Patentamt

European Patent Office

Office européen des brevets

(11) Publication number: 0 355 464 A2

# EUROPEAN PATENT APPLICATION

(21) Application number: 89113866.1

(51) Int. Cl.4 H01L 29/73

(22) Date of filing: 27.07.89

(30) Priority: 15.08.88 US 232088

(43) Date of publication of application:
28.02.90 Bulletin 90/09

(84) Designated Contracting States:
DE FR GB

(71) Applicant: MOTOROLA, INC.
1303 East Algonquin Road
Schaumburg Illinois 60196(US)

(72) Inventor: Tsui, Raymond K.
7911 E. San Miguel No.8
Scottsdale Arizona 85263(US)
Inventor: Curless, Jay A.
7110 E. Continental 125
Scottsdale Arizona 85257(US)
Inventor: Kramer, Gary D.
6022 E. Windsor
Scottsdale Arizona 85257(US)
Inventor: Peffley, Marilyn Sue
1320 E. Highland Avenue No.54
Phoenix Arizona 85014(US)

(74) Representative: Holt, Michael et al
MOTOROLA European Intellectual Property
Operations Jays Close, Viables Ind. Est.
Basingstoke Hants, RG22 4PD(GB)

(54) Heterojunction bipolar transistor formed on a critically misoriented substrate.

(57) A heterojunction bipolar transistor (10,28,44) wherein semiconductor collector (14,34,46), base (16,32,48) and emitter (18,30,50) layers are grown on a critically misoriented semiconductor substrate (12) using molecular beam epitaxy. The present invention may be applied to both single heterojunction bipolar transistors (10,28) and double heterojunction bipolar transistors (44).

FIG. 1

# HETEROJUNCTION BIPOLAR TRANSISTOR FORMED ON A CRITICALLY MISORIENTED SUBSTRATE

## Background of the Invention

This invention relates, in general, to semiconductor devices, and more particularly to a heterojunction bipolar transistor formed on a critically misoriented semiconductor substrate.

Heterojunction bipolar transistors fabricated from epitaxial semiconductor structures offer higher performances than silicon homojunction bipolar transistors in terms of speed, power and operational frequency. Perhaps the most common compound semiconductor material system employed for this type of application comprises AlGaAs and GaAs. An undesirable property of devices fabricated from this compound semiconductor material system is the presence of a collector-emitter offset voltage ($V_{ce}$) When the emitter-base junction is forward-biased in the emitter-up single heterojunction bipolar transistor configuration, the collector current is zero. The offset voltage increases the collector-emitter saturation voltage which in turn raises the power consumption in logic circuits and reduces the active region of operation in analog circuits.

The collector-emitter offset voltage was originally attributed to the higher turn-on voltage of the emitter-base heterojunction as compared to that of the base-collector homojunction. However, the use of double heterojunction bipolar transistors which are expected to have equal turn-on voltages for both junctions due to the symmetrical configuration of the structures, was not totally successful in the elimination of the collector- emitter offset voltage. A likely reason is that the emitter-base heterojunction is of a higher quality than the base-collector heterojunction. These structures are usually grown by molecular beam epitaxy where it is known that certain necessary growth conditions produce rough surface morphology. For example, AlGaAs grown on top of the smooth GaAs <100> oriented substrate results in a smooth heterointerface. However, as the growth of the AlGaAs layer continues, the surface morphology becomes rough and causes a rough heterointerface when GaAs is grown on the rough AlGaAs. In the case of a double heterojunction bipolar transistor in the emitter-up configuration, the base-collector heterojunction is formed by growing the GaAs base layer on top of the AlGaAs collector layer thereby creating a rough interface. Therefore, fabricating a single or double heterojunction bipolar transistor having high quality emitter-base and base-collector heterojunctions would be very useful in that the collector-emitter offset voltage may be eliminated or reduced.

## Summary of the Invention

Accordingly, it is an object of the present invention to provide a heterojunction bipolar transistor having greatly reduced or eliminated collector-emitter offset voltage.

Another object of this invention is to provide a heterojunction bipolar transistor having high quality heterojunctions.

It is an additional object of the present invention to provide a heterojunction bipolar transistor wherein the surface morphology of the various epitaxial compound semiconductor materials is smooth.

Yet a further object of the present invention is to provide a heterojunction bipolar transistor wherein the growth of high quality AlGaAs with smooth surface morphology can be achieved at substrate temperatures below 700 degrees centigrade.

Yet a further object of the present invention is to provide a heterojunction bipolar transistor having superior electronic transport properties and better device performance.

The foregoing and other objects and advantages are achieved in the present invention by one embodiment in which, as apart thereof includes forming a heterojunction bipolar transistor on a critically misoriented semiconductor substrate. The critically misoriented semiconductor substrate allows for high quality heterojunctions because the various epitaxial compound semiconductor layers of the device have smooth surface morphologies. Additionally, the critically misoriented semiconductor substrate allows for the various layers of epitaxial compound semiconductor material to be grown at lower temperatures.

## Brief Description of the Drawings

FIG. 1 is a highly enlarged cross-sectional view of a single heterojunction bipolar transistor;

FIG. 2 is a highly enlarged cross-sectional view of an inverted single heterojunction bipolar transistor; and

FIG. 3 is a highly enlarged cross-sectional view of a double heterojunction bipolar transistor.

## Detailed Description of the Invention

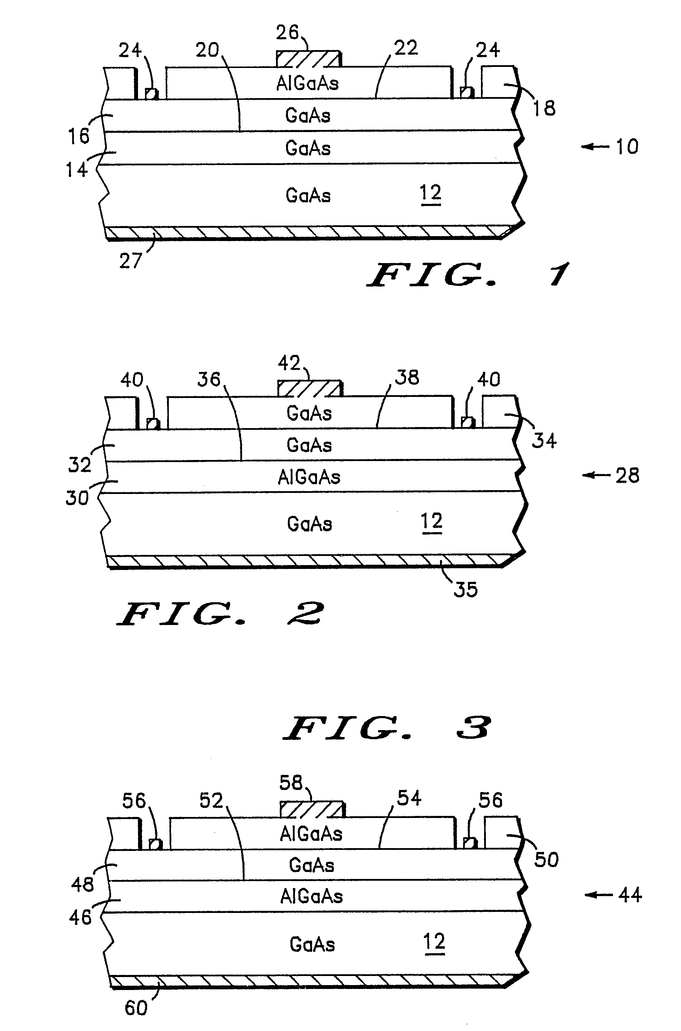

Referring specifically to FIG. 1, a highly enlarged cross-sectional view of a single heterojunction bipolar transistor (SHBT) 10 is shown. SHBT 10 includes a semiconductor substrate 12. In this embodiment, semiconductor substrate 12 is comprised of gallium arsenide (GaAs) however, it should be understood that semiconductor substrate 12 may be comprised of various other semiconductor materials. Further, in this embodiment, semiconductor substrate 12 is doped. If SHBT 10 is an NPN transistor, semiconductor substrate 12 has an N conductivity type. If SHBT 10 is a PNP transistor, semiconductor substrate 12 has a P conductivity type. It should be understood that the doping of semiconductor substrate 12 allows the use of a backside collector contact. However, in other embodiments, semiconductor substrate 12 may be semi-insulating thereby causing contacts to be formed in other ways which will be discussed presently.

Semiconductor substrate 12 is critically misoriented. In this embodiment, GaAs substrate 12 is misoriented from the <100> orientation towards the <111> gallium orientation. One skilled in the art will understand that critical misorientation is the misorientation of a surface so as to allow for a smooth surface having a lower surface energy than that of a rough surface. Critically misorienting semiconductor substrate 12 allows for high quality semiconductor layers having smooth surface morphologies to be grown thereon. This in turn allows for smooth interfaces along the heterojunctions in heterojunction bipolar transistors such as SHBT 10.

A semiconductor collector layer 14 is grown on GaAs substrate 12. Semiconductor collector layer 14 is comprised of GaAs and doped during formation. It should be understood that collector layer 14 is doped in the same conductivity type as semiconductor substrate 12 in those embodiments where a conductive semiconductor substrate 12 is used. It should be understood that it is well known in the art to employ a buffer layer between semiconductor substrate 12 and collector layer 14. The buffer layer is generally considered a part of collector layer 14. A semiconductor base layer 16 is then grown on collector layer 14. Base layer 16 is comprised of GaAs and is also doped as it is formed. However, base layer 16 is doped in the opposite conductivity type to that of collector layer 14. Once base layer 16 has been formed, a semiconductor emitter layer 18 is grown thereon. Emitter layer 18 is comprised of aluminum gallium arsenide (AlGaAs) and is also doped during formation. It should be understood that the conductivity type of emitter layer 18 will be the same as that of collector layer 14.

One skilled in the art will understand that a homojunction 20 has been formed between collector layer 14 and base layer 16. The homojunction is a result of collector layer 14 and base layer 16 both being comprised of the same material, GaAs in this embodiment. A heterojunction 22 has been formed between base layer 16 and emitter layer 18. Heterojunction 22 results because base layer 16 and emitter layer 18 are comprised of different materials, GaAs and AlGaAs respectively in this embodiment.

SHBT 10 includes a pair of base contacts 24. Once emitter layer 18 has been formed, openings are etched through it that extend to base layer 16. Metal base contacts 24 are then formed in the openings. Emitter layer 18 is contacted by emitter contact 26 which is also metal. Because semiconductor substrate 12 is conductive in this embodiment, collector layer 14 may be contacted through a metal collector contact 27 formed on the backside of semiconductor substrate 12. If semiconductor substrate 12 were semi-insulating in this embodiment, a separate collector contact would have to be formed by etching an opening through emitter layer 18 and base layer 16 to collector layer 14 and then making contact to collector layer 14 through the opening.

Referring to FIG. 2, a highly enlarged cross-sectional view of an inverted SHBT 28 is shown. Inverted SHBT 28 includes critically misoriented semiconductor substrate 12 which is also comprised of GaAs in this embodiment. GaAs substrate 12 is critically misoriented from the <100> orientation towards the <111> gallium orientation. Again, GaAs substrate 12 is doped in this embodiment.

A semiconductor emitter layer 30 is formed directly on semiconductor substrate 12. Emitter layer 30 is comprised of AlGaAs in this embodiment. Emitter layer 30 is doped during formation and is of the same conductivity type as semiconductor substrate 12. Again, a buffer layer may be formed between semiconductor substrate 12 and emitter layer 30 as discussed earlier. Next, a GaAs base layer 32 is grown on emitter layer 30. Base layer 32 is doped during formation in a conductivity type opposite that of emitter layer 30. Following the formation of base layer 32, a semiconductor collector layer 34 is formed. Collector layer 34 is comprised of GaAs in this embodiment and is doped during formation in the same conductivity type as emitter layer 30.

In this embodiment, a heterojunction 36 is formed between emitter layer 30 and base layer 32 while a homojunction 38 is formed between base layer 32 and collector layer 34. Base contacts 40 are formed in the same way as described in FIG. 1 and collector contact 42 is formed on collector layer 34. Emitter layer 30 is contacted through a metal emitter contact 35 formed on the backside of doped semiconductor substrate 12. Again, if a semi-insulating semiconductor substrate 12 were used, a separate emitter contact would be formed by etching an opening through collector layer 34 and base layer 32 to contact emitter layer 30 and then making contact to emitter layer 30 through the opening.

FIG. 3 is a highly enlarged cross-sectional view of a double heterojunction bipolar transistor (DHBT) 44. DHBT 44 includes semiconductor substrate 12 which is comprised of GaAs in this embodiment. GaAs substrate 12 is critically misoriented from the <100> orientation towards the <111> gallium orientation. It should further be understood that semiconductor substrate 12 is a conductive substrate in this embodiment. A semiconductor collector layer 46 is formed on semiconductor substrate 12. In this embodiment, collector layer 46 is comprised of AlGaAs and is doped in the same conductivity type as semiconductor substrate 12 during its formation. A GaAs base layer 48 is formed on collector layer 46. Collector layer 46 may include a buffer layer disposed between it and semiconductor substrate 12. GaAs base layer 48 is doped during formation in a conductivity type opposite that of collector layer 46. An emitter layer 50 comprised of AlGaAs is formed on base layer 48. Emitter layer 50 is doped during formation and is of a conductivity type the same as collector layer 46.

In this embodiment, a heterojunction 52 is formed between collector layer 46 and base layer 48 while another heterojunction 54 is formed between base layer 48 and emitter layer 50. Base contacts 56 are formed in the same manner as described above while an emitter contact 58 is formed in the same manner as was emitter contact 26 in FIG. 1. Collector layer 46 is contacted through a metal collector contact 60 formed on the backside of conductive semiconductor substrate 12. Again, if semiconductor substrate 12 were semi-insulating a collector contact would be formed by etching an opening through emitter layer 50 and base layer 48 to collector layer 46 and then contact is made to collector layer 46 through the opening.

The various epitaxial layers that comprise the collector layers, base layers and emitter layers in the above embodiments are grown on critically misoriented semiconductor substrate 12 by molecular beam epitaxy. Molecular beam epitaxy is a physical deposition process wherein evaporation of the source materials occurs in a vacuum environment. Both critically misoriented semiconductor substrate 12 and source materials of the types to be deposited thereon are heated in the vacuum environment.

Commonly, the optimal growth temperature of AlGaAs is much higher than that of GaAs. Therefore, when AlGaAs/GaAs heterointerfaces are formed, the growth of one or both materials occurs at a non-optimum temperature. This results in a degraded heterointerface. However, semiconductor substrate 12, by being critically misoriented, allows smooth AlGaAs layers to be grown at lower substrate temperatures. These lower temperatures would create rough surface morphologies if grown on a substrate having a nominally <100> orientation. The smooth surface AlGaAs layers allow for improved heterointerfaces in HBTs because the growth temperatures of GaAs and AlGaAS have less disparity between them. This results in greatly reduced collector-emitter offset voltage, especially in DHBTs.

High quality material layers having smooth heterointerfaces may be grown on critically misoriented semiconductor substrate 12 at temperatures in the range of 600 to 680 degrees centigrade. Preferred temperatures are approximately 620 degrees centigrade for GaAs and approximately 650 degrees centigrade for AlGaAs. Additionally, the use of critically misoriented semiconductor substrate 12 allows for high quality layers of AlGaAs and GaAs to be grown at a constant temperature somewhere in the range of 600 to 680 degrees centigrade.

Although heterojunction bipolar transistor fabrication using the GaAs/AlGaAs material system has been described above, it should be understood that the present invention may be employed using other compound semiconductor material systems such as those based on AlSb/InAs and InGaAsP/InP. Further, HBTs using the present invention may be fabricated from elemental semiconductors and their alloys such as Si/SiGe.

## Claims

1. A heterojunction bipolar transistor (10, 28,44), the invention being characterized by:
a critically misoriented semiconductor substrate (12)
a semiconductor emitter layer (18,30,50), semiconductor collector layer (14,34,46) and a semiconductor base layer (16,32,48) disposed therebetween, said emitter (18,30,50), collector (14,34,46) and base (16,32,48) layers being disposed on said critically misoriented semiconductor substrate (12).

2. The heterojunction bipolar transistor (10,44) of claim 1 wherein the semiconductor collector layer (14,46) is disposed on the critically misoriented semiconductor substrate (12).

3. The heterojunction bipolar transistor (28) of claim 1 wherein the semiconductor emitter layer (30) is disposed on the critically misoriented semiconductor substrate (12).

4. The heterojunction bipolar transistor (10,28) of claim 1 wherein the semiconductor emitter layer (18,30) is comprised of a material having a larger band gap than the material comprising the semiconductor collector (18,24) layer and semiconductor base layer (16,32).

5. The heterojunction bipolar transistor (44) of claim 1 wherein the semiconductor emitter layer (50) and the semiconductor collector layer (46) are both comprised of a material having a larger band gap than the material comprising the semiconductor base layer (48).

6. The heterojunction bipolar transistor (10, 28, 44) of claim 1 wherein the critically misoriented semiconductor substrate (12) is comprised of GaAs and is misoriented from the <100> orientation towards the <111> Ga orientation.

7. The heterojunction bipolar transistor (10,28) of claim 6 wherein the semiconductor emitter layer (18,30) is comprised of AlGaAs while the semiconductor base layer (16,32) and the semiconductor collector layer (18,34) are comprised of GaAs.

8. The heterojunction bipolar transistor (44) of claim 6 wherein the semiconductor emitter layer (50) and the semiconductor collector layer (46) are comprised of AlGaAs while the semiconductor base layer (48) is comprised of GaAs.

*FIG. 1*

*FIG. 2*

*FIG. 3*